# EUROPEAN PATENT APPLICATION

(11) **EP 4 265 819 A1**
(43) Date of publication of application: **25.10.2023**
(21) Application number: 23168758.3
(22) Date of filing: 19.04.2023
(51) Int. Cl.: C23C 14/50, C23C 16/458

(54) **IMPROVED APPARATUS AND METHOD FOR COATING ARTICLES BY PHYSICAL VAPOR DEPOSITION TECHNIQUE**

(30) Priority: 20.04.2022 IT 202200007826
(71) Applicant: Kolzer S.r.l., 20158 Milano (IT)
(72) Inventor: GIAMBAVICCHIO, Antonio, 10020 Cambiano (TO) (IT)
(74) Representative: Rastelli, Franco

(57) **Abstract**

An apparatus and method for coating articles with a Physical Vapor Deposition technique, wherein articles (3) are subjected to a rotation about a first axis (X1) and simultaneously to a rotation about a second axis (X2) parallel to said axis (X1). According to the invention, the aforesaid articles (3) are also subjected, during said rotations about said axes (X1,X2), to a rotation about a third axis (Y) perpendicular to the aforesaid axes (X1,X2). Compared to the prior art of the sector, the apparatus and method of the invention have the advantage of equally exposing all the surfaces of the article to the stream of the coating material, so that the article can be coated with a coating layer having a uniform and homogeneous thickness.

## Description

### BACKGROUND OF THE INVENTION

The present invention relates to an improved apparatus and method for coating articles in general with the so-called Physical Vapor Deposition technique.

The field of the invention is that of apparatuses which implement the deposition of an outer coating of materials, such as metal, ceramic, graphite, and the like, on articles in general, such as containers and bottles for cosmetic products, bottles, buttons, and the like.

The methods currently used to make this type of coating are based on the so-called Physical Vapor Deposition or PVD technology, wherein the material used for coating the objects is transferred, in a vaporized form, starting from a solid source of the same starting material. In particular, either a process of thermal evaporation of atoms or a deposition by means of cathodic vaporization technology, or "sputtering", is carried out on said starting material.

In this type of application, the articles to be coated are fixed onto rotating planet gears, which, in turn, are arranged rotating on a planetary gear set system, also rotating about a respective axis, perpendicular to the stream of the material used for the coating. The rotational axes of the planetary gear set system and planet gears are mutually parallel and are also arranged so that their relative motion exposes the object to the stream of the material used to coat it. This deposition of material occurs on the surfaces of the articles which are oriented perpendicularly to the direction of the stream, i.e., for an object with a parallelepiped-shaped body, the two opposing side surfaces, the top and the bottom. The other two side surfaces, which are exposed to the stream of the coating material in a direction parallel and not perpendicular to the feeding direction of the coating material, receive a smaller amount of material than the other surfaces of the article, resulting in the formation of undesirable lack of homogeneity or dissimilarities in the thickness of the coating thus made.

### SUMMARY OF THE INVENTION

It is the main object of the present invention to provide an apparatus and method for coating articles with the PVD technique, which, unlike similar systems of the prior art, make it possible to overcome the drawbacks mentioned above.

This and other objects are achieved with the method and the device of claims 1 and 2, respectively. Preferred embodiments of the invention will be apparent from the remaining claims.

Compared to the prior art in this sector, the apparatus and method of the invention have the advantage that all the surfaces of an article, i.e. the object or part to be coated, are equally exposed to the stream of the coating material so that the article can be coated with a coating layer having a uniform and homogeneous thickness.

The apparatus and method of the invention also have the advantage of achieving a homogeneous coating, even at deviations of the material stream with respect to the direction perpendicular to the surfaces to be coated.

### BRIEF DESCRIPTION OF THE DRAWINGS

These and other objects, advantages, and features will be apparent from the following description of preferred embodiments of the apparatus and the method according to the invention, illustrated by way of non-limiting examples in the figures of the accompanying drawing sheets, in which:
- Figure 1 shows an operation diagram of conventional apparatuses for coating objects with PVD technique;

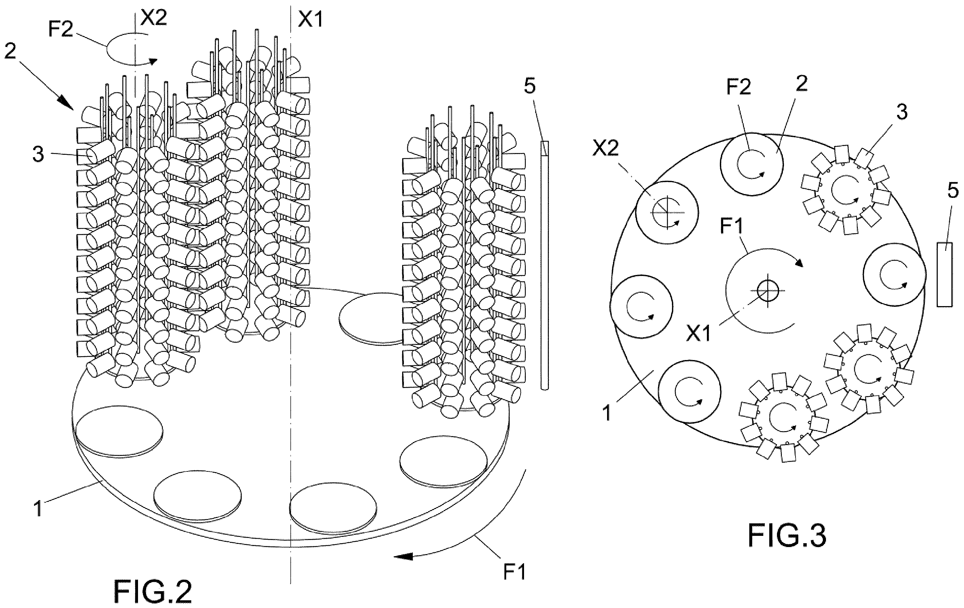

- Figures 2 and 3 illustrate perspective and plan views, respectively, of the apparatus in Figure 1;
- Figure 4 illustrates an example of an article treated with the apparatus of the invention;
- Figure 5 illustrates an operation diagram of the apparatus of the invention;
- Figures 6 and 7 illustrate perspective and plan views, respectively, of the apparatus of the invention;
- Figure 8 illustrates the planet gear equipped on the apparatus of the invention;
- Figure 9 illustrates detail A of the planet gear in Figure 8;
- Figures 10 and 11 illustrate the movement mechanism of the planetary gear set system and planet gears of the apparatus of the invention.

### DETAILED DESCRIPTION OF THE PREFERRED EMBODIMENTS

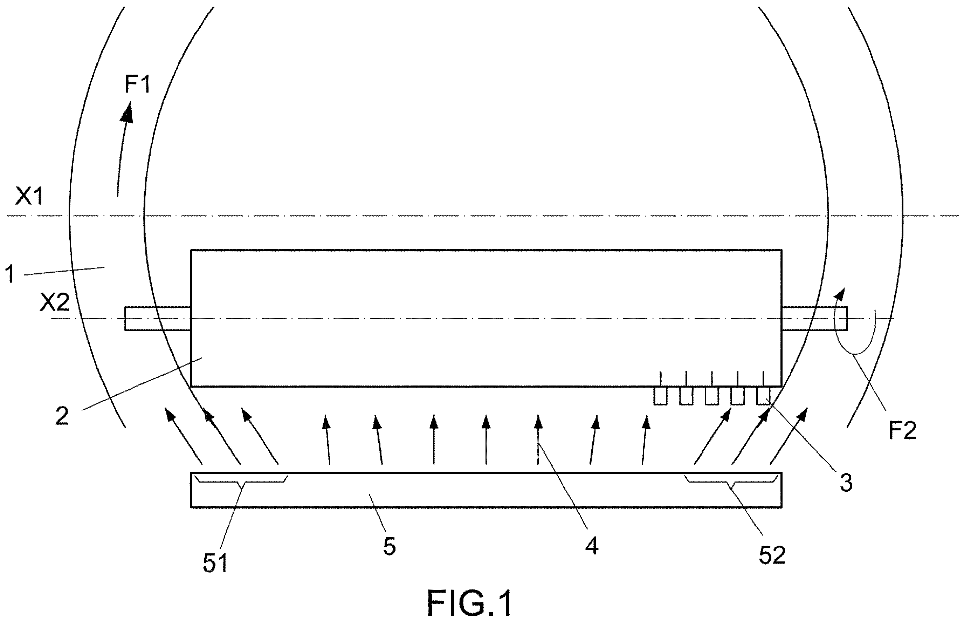

The apparatus of the prior art shown in Figure 1, which is used for coating articles with PVD technology, comprises a plurality of planet gears 2, arranged rotating about their axis X2, either horizontal or vertical, in the direction of the arrow F2, either clockwise or counterclockwise.

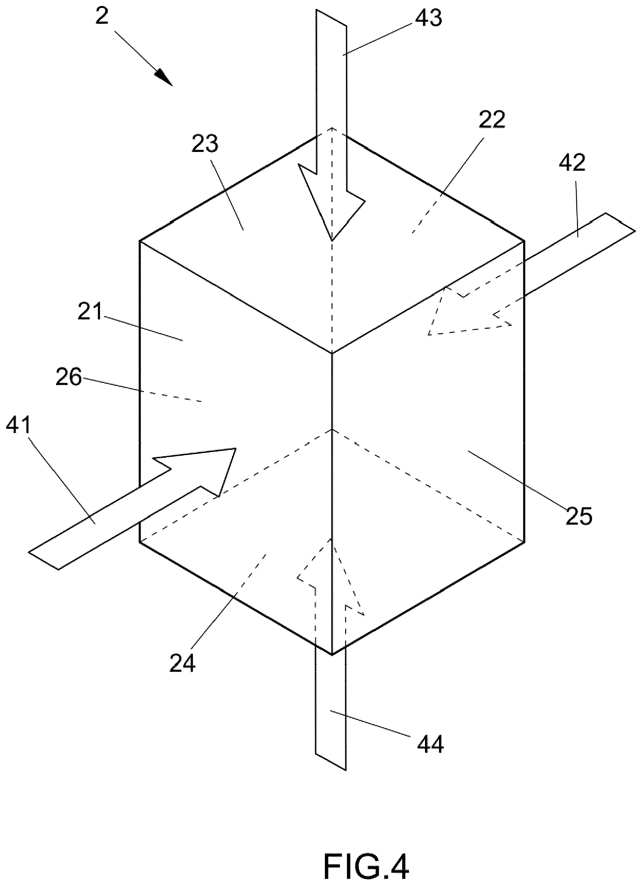

The articles 3, which have to be coated with metal, ceramic, or other with PVD technology, are fixed onto the planet gears 2. In the example shown in Figure 4, a parallelepiped-shaped article is shown for the sake of convenience of exposition, but objects of any shape are obviously possible, such as cylinders and yet other.

The assembly of planet gears 2 and articles 3 is, in turn, mounted on a planetary gear set system 1 which is rotatable, in the direction of arrow F1, also either clockwise or counterclockwise, about the axis X1 of the planetary gear set system, parallel to the axis X2 of the planet gears 2.

During the described rotations of the planet gears 2 and planetary gear set system 1, which are mutually simultaneous, the parallelepiped-shaped article 3 shown in Figure 4 is struck by the streams 4 of the coating material, released from the source or target 5 of Figure 1, in the directions 41 and 42 perpendicular to the surfaces 21 and 22 of the article 3, and in the directions 43 and 44 perpendicular to the surfaces 23 and 24 of the article 3, respectively, as shown in the diagram in Figure 4.

The remaining surfaces 25 and 26 of the article 3, on the other hand, receive the aforementioned streams 41, 42, 43, and 44 either askew or parallel, i.e., no longer in their proper perpendicular direction. For this reason, a lack of homogeneity is found in the coating thickness on the aforementioned surfaces 25 and 26, in particular, a smaller thickness than that of the coating deposited on the surfaces 21, 22, 23, 24 of the article 3.

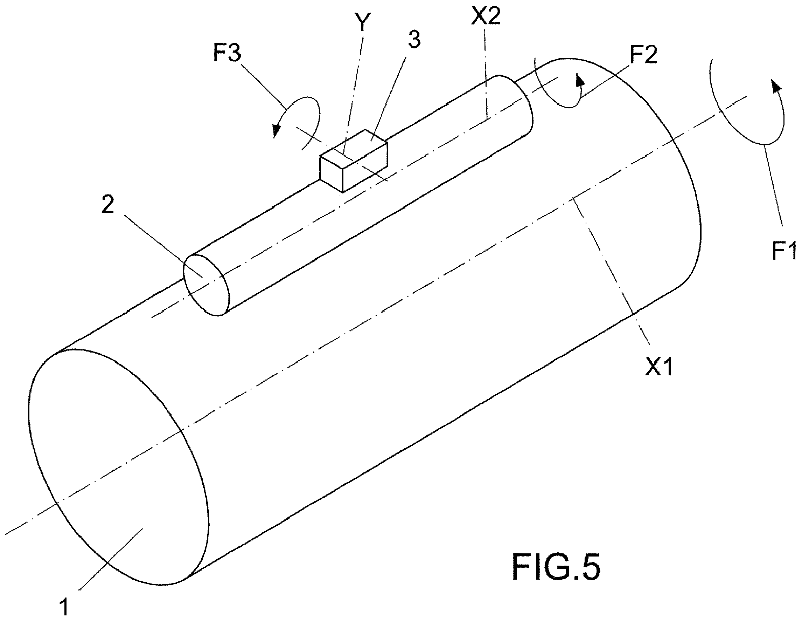

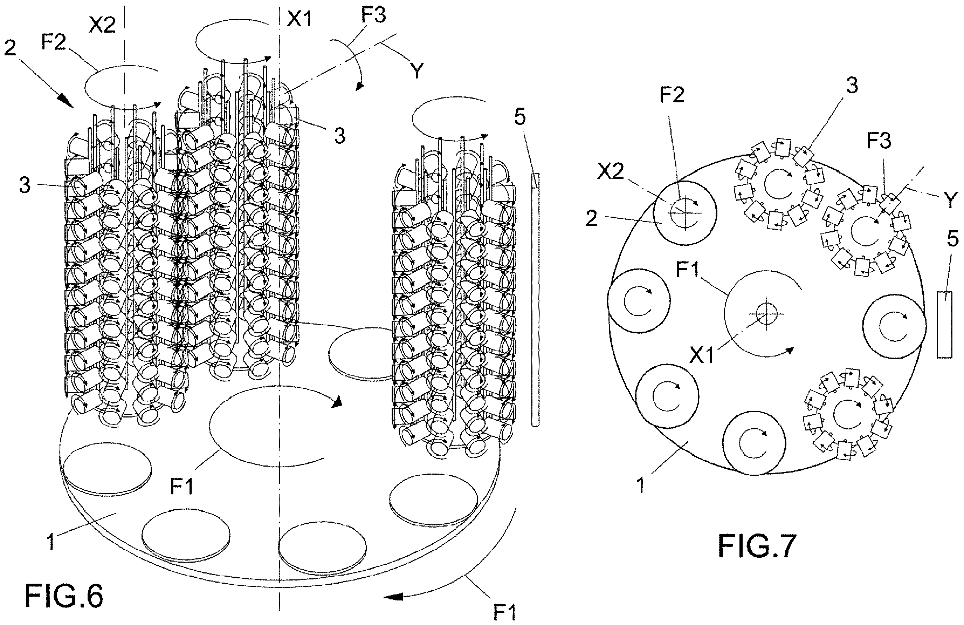

By virtue of the apparatus and method of the invention, the described drawback of the prior art is overcome by imparting, in the system of planetary gear set 1 and planet gears 2 rotating about their respective mutually parallel axes X1 and X2, also a rotation to the objects 3 to be coated, according to their axis Y perpendicular to the aforesaid axes X1 and X2 and in the clockwise or counterclockwise direction of arrow F3 of Figures 5 to 7.

Indeed, according to the invention, a method is provided for coating articles 3 with PVD technique, wherein these articles are subjected to a rotation about a first axis X1 and simultaneously to a rotation about a second axis X2 parallel to the axis X1, wherein the articles 3 are also subjected, during the described rotations about the axes X1 and X2, to a rotation about a third axis Y perpendicular to the same axes X1 and X2.

By means of the described rotation imparted to all the articles 3 to be coated and fixed to the planet gears 2, the surfaces 25 and 26 of these articles also receive the streams 41 and 42 of the coating material in the direction perpendicular thereto, which is suited to avoid the formation of lack of homogeneity in the thickness of the material of this coating.

By virtue of the same rotation of the articles 3 according to their axis Y, the uniformity of the coating distribution is also achieved at the fields 51 and 52 of the streams 4 of coating material, diverted from the correct original direction (Figure 1). In this manner, the complete utilization of the entire stream of material fed from the source 5 is achieved, with the formation of a regular and homogeneous coating on all the articles 3 mounted on the planet gears 2.

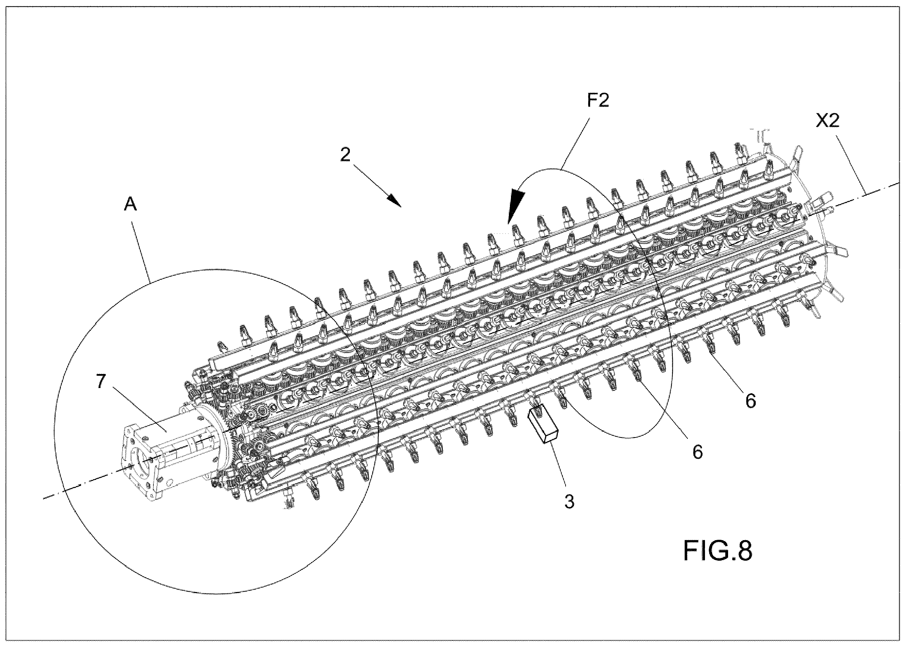

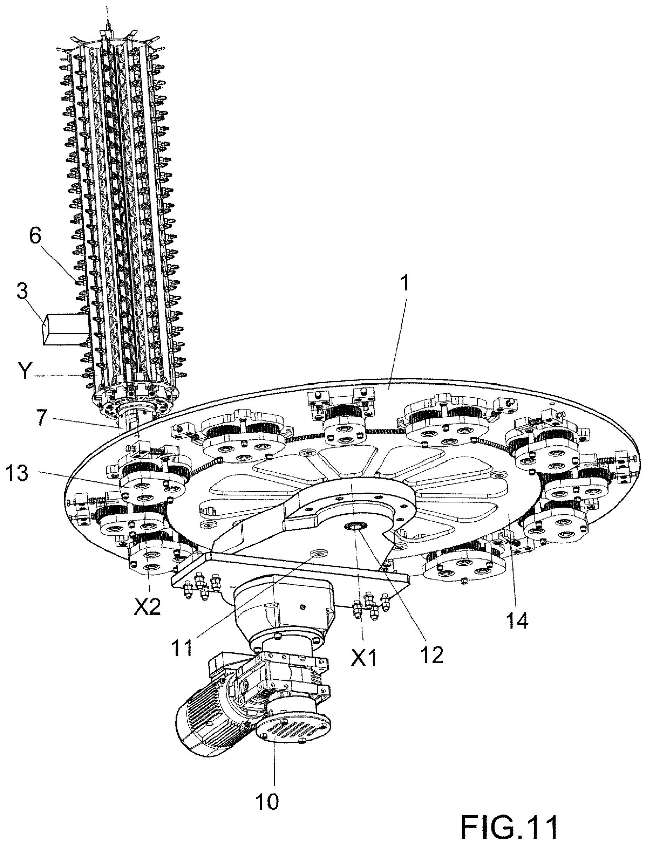

As better illustrated in Figures 8 through 11, each planet gear 2 is equipped with an epicyclic reduction gear 7 which, in order to allow the rotation of the planet gears 2 about their axis X2, is constrained to the impeller 13 mounted on the housing of each planet gear on the planetary gear set system 1.

In turn, the impeller 13 receives its motion from the rotation of the toothed wheel 14 fixed to the frame of the apparatus and thus stationary relative to the rotational movement of the planetary gear set system 1.

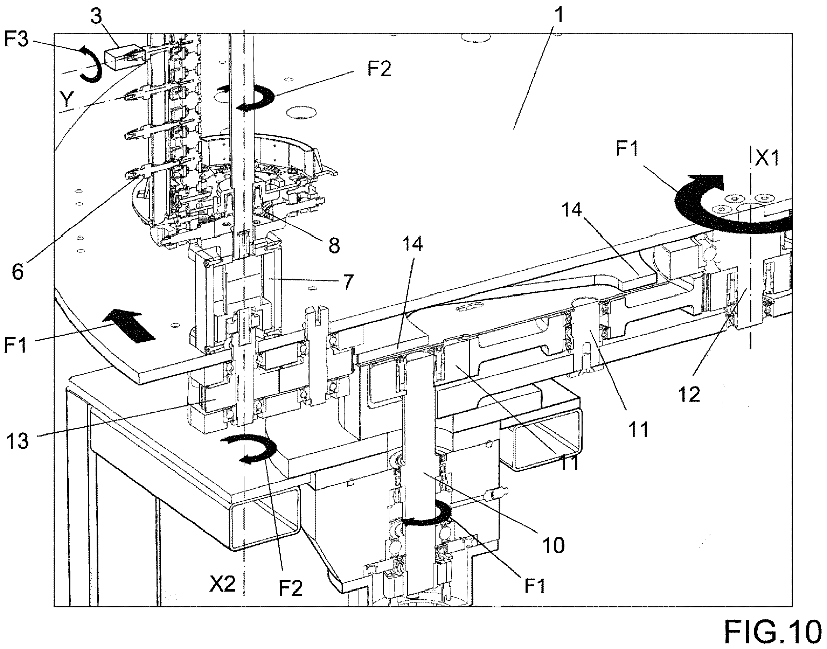

In particular, the planetary gear set system 1 is mounted rotatable about its bearing shaft 12 by means of the kinematic mechanism formed by the drive shaft 10 and the transmission 11, which are better shown in Figure 10.

As described above, the epicyclic reduction gear 7 is constrained to the planetary gear set system 1, and, when the planet gear 2 begins its rotation about the axis X2, simultaneously to the rotation of the planetary gear set system about the axis X1, the rotation of the articles 3 about their axis Y also takes place simultaneously.

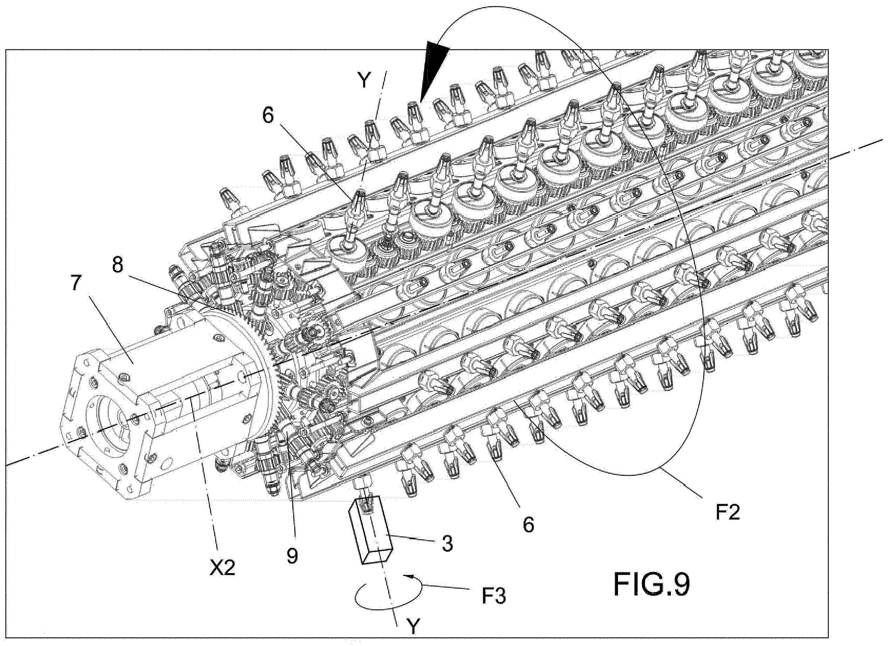

For this purpose, the epicyclic reduction gear 7 is provided with a toothed wheel 8, which meshes with revolving pinions 9, which, in turn, are joined in rotation to the supports 6 of the articles 3 by means of a corresponding kinematic chain, better shown in Figure 9.

## Claims

1. A method for coating articles by using a Physical Vapor Deposition technique, wherein said articles (3) are subjected to a rotation about a first axis (X1) and simultaneously to a rotation about a second axis (X2) parallel to said axis (X1), **characterized in that** said articles (3) are also subjected, during said rotations about said axes (X1,X2), to a rotation about a third axis (Y) perpendicular to the same axes (X1 ,X2), wherein said rotation of said articles (3) about said axis (Y) is promoted by said rotations of the articles (3) about said axes (X1 ,X2).

2. An apparatus for implementing the method according to claim 1, of the type comprising a plurality of planet gears (2) rotating about an axis (X2) and carrying rotatable supports (6) for said articles (3) to be coated, said apparatus further comprising a planetary gear set system (1) rotating about an axis (X1) parallel to said axis (X2) and on which said planet gears (2) are supported, **characterized in that** a transmission for rotating said rotatable supports (6) for said articles (3) about their axis (Y) perpendicular to the preceding axes (X1,X2) is further provided, wherein the rotation of said supports (6) is achieved by means of the rotation of the planetary gear set system (1) about its axis (X1), through the rotation of said planet gears (2) about the said axis (X2).

3. An apparatus according to claim 2, **characterized in that** said transmission for rotating the supports (6) of said articles (3) about their axis (Y) comprises an epicyclic reduction gear (7) associated with each of said planet gears (2).

4. An apparatus according to claim 3, **characterized in that** each epicyclic reduction gear (7) has a toothed wheel (8) which meshes with rotating pinions (9), which, in turn, are joined in rotation with said supports (6) of the articles (3) by means of a corresponding kinematic chain.

5. An apparatus according to claim 4, **characterized in that** said epicyclic reduction gear (7) is constrained to a corresponding impeller (13), which, in turn, is mounted on the housing of each planet gear on the planetary gear set system (1), to allow the rotation of the planet gears (2) about their axis (X2) by means of the transmission of the impeller (13) with a toothed wheel (14), which is kept stationary relative to the movements of the planetary gear set system (1).

6. An apparatus according to claim 5, **characterized in that** a drive shaft (10) and a transmission (11) for rotating said planetary gear set system (1) about its bearing shaft (12) are provided.
